# EUROPEAN PATENT APPLICATION

(11) **EP 3 996 160 A1**
(43) Date of publication of application: **11.05.2022**
(21) Application number: 21193529.1
(22) Date of filing: 27.08.2021
(51) Int. Cl.: H01L 51/42

(54) **PHOTOELECTRIC CONVERSION ELEMENT, COATING LIQUID, COATING METHOD, AND COATING APPARATUS**

(30) Priority: 06.11.2020 JP 2020185606
(71) Applicant: Kabushiki Kaisha Toshiba, Minato-ku Tokyo (JP)
(72) Inventor: Shimo, Shunsuke, Minato-ku, Tokyo (JP); Mori, Shigehiko, Minato-ku, Tokyo (JP); Todori, Kenji, Minato-ku, Tokyo (JP); Mizuguchi, Koji, Minato-ku, Tokyo (JP)
(74) Representative: Hoffmann Eitle

(57) **Abstract**

According to one embodiment, a photoelectric conversion element includes a first conductive layer (21), a second conductive layer (22), and a photoelectric conversion layer (11) located between the first conductive layer and the second conductive layer. The photoelectric conversion layer includes a perovskite compound and a first compound. The first compound includes at least one selected from the group consisting of a pyrrolidone derivative, a urea derivative, an imidazole derivative, a pyridine derivative, and a diamine derivative.

## Description

### FIELD

Embodiments described herein relate generally to a photoelectric conversion element, a coating liquid, a coating method, and a coating apparatus.

### BACKGROUND

For example, a photoelectric conversion element is manufactured by a coating method or the like. It is desirable to improve the characteristics of the photoelectric conversion element.

### BRIEF DESCRIPTION OF THE DRAWINGS

FIG. 1 is a schematic cross-sectional view illustrating a photoelectric conversion element according to a first embodiment;
FIG. 2 is a graph illustrating characteristics of the photoelectric conversion element;
FIG. 3 is a graph illustrating characteristics of the photoelectric conversion element;
FIGS. 4A and 4B are graphs illustrating analysis results of the photoelectric conversion element;
FIGS. 5A to 5C are graphs illustrating analysis results of the photoelectric conversion element;
FIG. 6 is a flowchart illustrating a coating method according to a third embodiment;
FIG. 7 is a schematic side view illustrating a coating apparatus used in the coating method according to the third embodiment;
FIG. 8 is a graph illustrating a characteristic relating to the coating method; and
FIGS. 9A to 9C are schematic views illustrating the coating apparatus according to a fourth embodiment.

### DETAILED DESCRIPTION

According to one embodiment, a photoelectric conversion element includes a first conductive layer, a second conductive layer, and a photoelectric conversion layer located between the first conductive layer and the second conductive layer. The photoelectric conversion layer includes a perovskite compound and a first compound. The first compound includes at least one selected from the group consisting of a pyrrolidone derivative, a urea derivative, an imidazole derivative, a pyridine derivative, and a diamine derivative.

According to one embodiment, a coating liquid for photoelectric conversion element formation includes a perovskite precursor, a first compound, and a solvent. The perovskite precursor is used to form a perovskite compound. The first compound includes at least one selected from the group consisting of a pyrrolidone derivative, a urea derivative, an imidazole derivative, a pyridine derivative, and a diamine derivative.

According to one embodiment, a coating method is disclosed. The method can include coating a coating liquid onto a coated body by forming a meniscus between a coating bar and the coated body. The meniscus includes the coating liquid. The coating liquid includes a perovskite precursor, a first compound, and a solvent. The perovskite precursor is used to form a perovskite compound. The method can include forming a photoelectric conversion layer from the coating liquid by supplying a gas toward the coating liquid coated onto the coated body. A maximum air velocity of the gas at the coating liquid surface is not less than 4 m/s.

According to one embodiment, a coating apparatus includes a supporter configured to support a coated body, a coating bar, a coating liquid supplier, and a gas supplier. The coating liquid supplier is configured to coat a coating liquid onto the coated body by forming a meniscus between the coating bar and the coated body by supplying the coating liquid toward at least one of the coating bar or the coated body. The meniscus includes the coating liquid. The gas supplier is configured to supply a gas toward the coating liquid coated onto the coated body. A flow velocity of the gas is not less than 4 m/s.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### First embodiment

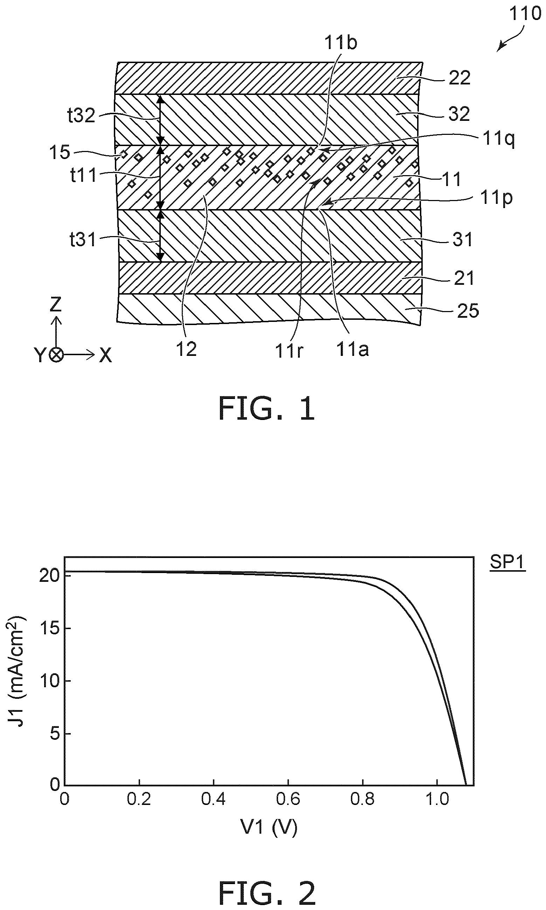

FIG. 1 is a schematic cross-sectional view illustrating a photoelectric conversion element according to a first embodiment.

As shown in FIG. 1, the photoelectric conversion element 110 according to the embodiment includes a first conductive layer 21, a second conductive layer 22, and a photoelectric conversion layer 11. The photoelectric conversion layer 11 is located between the first conductive layer 21 and the second conductive layer 22. The photoelectric conversion layer 11 includes a perovskite compound 12 and a first compound 15. The first compound 15 includes, for example, at least one selected from the group consisting of a pyrrolidone derivative, a urea derivative, an imidazole derivative, a pyridine derivative, and a diamine derivative.

In the example, the photoelectric conversion element 110 includes a first layer 31 and a second layer 32. The first layer 31 is located between the first conductive layer 21 and the photoelectric conversion layer 11. The second layer 32 is located between the photoelectric conversion layer 11 and the second conductive layer 22. The first layer 31 is, for example, one of a hole transport layer or an electron transport layer. The second layer 32 is, for example, the other of the hole transport layer or the electron transport layer.

The photoelectric conversion element 110 may include a base body 25. The base body 25 is, for example, a substrate. For example, the first conductive layer 21, the first layer 31, the photoelectric conversion layer 11, the second layer 32, and the second conductive layer 22 are located in this order on the base body 25.

A first direction from the first conductive layer 21 toward the second conductive layer 22 is taken as a Z-axis direction. One direction perpendicular to the Z-axis direction is taken as an X-axis direction. A direction perpendicular to the Z-axis direction and the X-axis direction is taken as a Y-axis direction. The first conductive layer 21, the second conductive layer 22, the photoelectric conversion layer 11, the first layer 31, the second layer 32, and the base body 25 spread along the X-Y plane.

As described above, the photoelectric conversion layer 11 according to the embodiment includes the perovskite compound 12 and the first compound 15. The first compound 15 is, for example, an additive. According to the embodiment as described below, the photoelectric conversion layer 11 is formed by coating a liquid (a coating liquid) that is used to form the photoelectric conversion layer 11 and by solidifying. For example, the coating liquid includes a solvent, the first compound 15, and a perovskite precursor that is used to form the perovskite compound 12. The photoelectric conversion layer 11 can be formed by using such a coating liquid.

It was found that good photoelectric conversion characteristics are obtained by the first compound 15 including materials such as those described above. Examples of characteristics of the photoelectric conversion element will now be described.

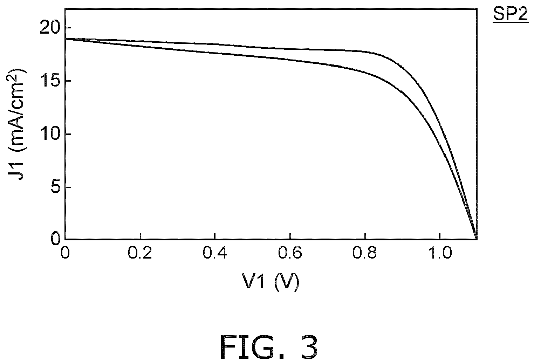

FIGS. 2 and 3 are graphs illustrating characteristics of the photoelectric conversion element.

In FIGS. 2 and 3, the horizontal axis is a voltage V1. The vertical axis is a current density J1. FIG. 2 corresponds to measurement results of characteristics of a first sample SP1. In the first sample SP1, the photoelectric conversion layer 11 is formed by coating a coating liquid that includes a solvent, the first compound 15, and a perovskite precursor used to form the perovskite compound 12. In the sample SP1, the photoelectric conversion layer 11 includes the perovskite compound 12 and the first compound 15. FIG. 3 corresponds to a second sample SP2. In the second sample SP2, the photoelectric conversion layer 11 is formed by coating a coating liquid that includes a solvent and a perovskite precursor used to form the perovskite compound 12. In the second sample SP2, the coating liquid does not include the first compound 15 described above. In the second sample SP2, the photoelectric conversion layer 11 includes the perovskite compound 12 but does not include the first compound 15.

As shown in FIGS. 2 and 3, compared to the second sample SP2, good photoelectric conversion characteristics are obtained in the first sample SP1.

The conversion efficiency of the first sample SP1 is 16.9%. The short-circuit current density is 20.3 mA/cm². The open-circuit voltage is 1.08 V. A form factor FF is 0.77.

The conversion efficiency of the second sample SP2 is 14.9%. The short-circuit current density is 19.0 mA/cm². The open-circuit voltage is 1.10 V. The form factor FF is 0.71.

Thus, a high conversion efficiency is obtained in the first sample SP1. According to the embodiment, a photoelectric conversion element can be provided in which the characteristics can be improved.

In microscopy of the photoelectric conversion layer 11, the photoelectric conversion layer 11 of the first sample SP1 was uniform compared to the photoelectric conversion layer 11 of the second sample SP2. It is considered that such a difference relates to the characteristic difference between the first sample SP1 and the second sample SP2.

The uniformity difference of the photoelectric conversion layer 11 relates to the existence or absence of a first compound 15 such as that described above. As described above, the first compound 15 includes at least one selected from the group consisting of a pyrrolidone derivative, a urea derivative, an imidazole derivative, a pyridine derivative, and a diamine derivative. It is considered that the perovskite compound 12 is easily dispersed uniformly by such a first compound 15. For example, it is considered that multiple regions (crystal regions) that include the perovskite compound 12 are easily dispersed uniformly at the surface of the coated body. For example, a high wettability is obtained due to the first compound 15.

It was found that due to a first compound 15 such as that described above, gaps between the multiple crystal regions in the perovskite compound 12 are substantially nil, and a dense crystal region is easily obtained. It is considered that a high conversion efficiency is obtained thereby.

For example, a coating liquid that includes a solvent, the first compound 15, and a perovskite precursor used to form the perovskite compound 12 is coated onto a coated body. The coated film is a liquid directly after coating. Subsequently, the solvent vaporizes, and a film that includes the perovskite compound 12 and the first compound 15 remains. It is considered that the first compound 15 moves at a moderate rate in the film in this process. Multiple crystal regions that include the perovskite compound 12 move in the film; and the crystal region are easily ordered. There is a possibility that gaps between the multiple regions that include the perovskite compound 12 are suppressed by the ordering of the crystal region; and the crystallinity is improved. It is considered that a good and dense crystal region is formed thereby. A high conversion efficiency is obtained thereby.

When the evaporation of the solvent is excessively slow, for example, the crystal region becomes excessively large, and gaps are easily formed between the multiple crystal regions. The conversion efficiency is reduced thereby. Also, when the evaporation of the solvent is excessively slow, for example, the productivity of the manufacture of the photoelectric conversion layer 11 by coating is reduced. When the evaporation of the solvent is excessively fast, for example, the ordering of the crystal region is insufficient; gaps are easily formed between the multiple crystal regions; and a dense crystal region is difficult to obtain. It is considered that the movement in the coated film and the ordering of the crystal region are easily promoted by a first compound 15 such as that described above. A good dense crystal region is obtained even for coating conditions at which the evaporation of the solvent is fast and high productivity is obtained. It is considered that a high conversion efficiency is obtained as a result.

It was found that a concentration difference easily occurs in the first compound 15 in the coated film (i.e., the photoelectric conversion layer 11) for a first compound 15 such as that described above.

For example, as shown in FIG. 1, the photoelectric conversion layer 11 includes a first region 11p and a second region 11q. The second region 11q is between the first region 11p and the second conductive layer 22. For example, a concentration difference easily occurs in the first compound 15 of the first and second regions 11p and 11q.

As shown in FIG. 1, for example, the photoelectric conversion layer 11 includes a first surface 11a at the first conductive layer 21 side and a second surface 11b at the second conductive layer 22 side. The second surface 11b is between the first surface 11a and the second conductive layer 22. The first region 11p includes the first surface 11a. The second region 11q includes the second surface 11b.

Examples of analysis results of the photoelectric conversion layer 11 will now be described.

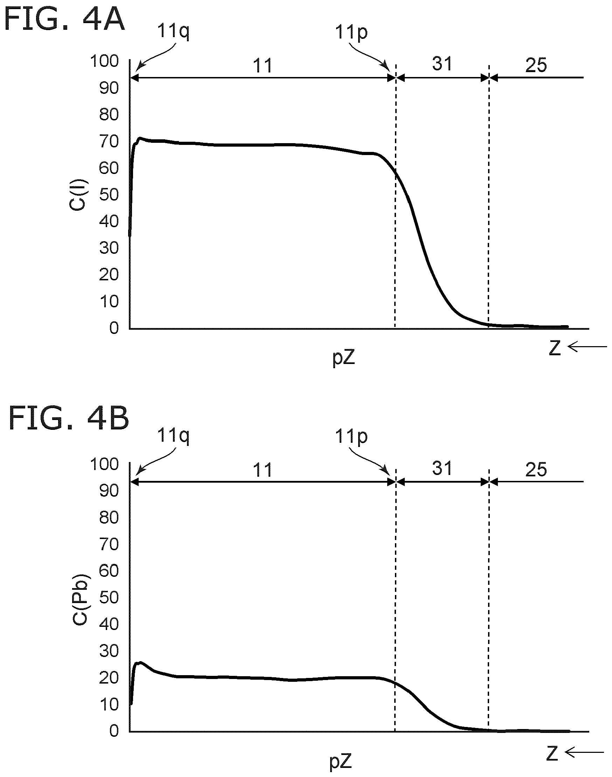

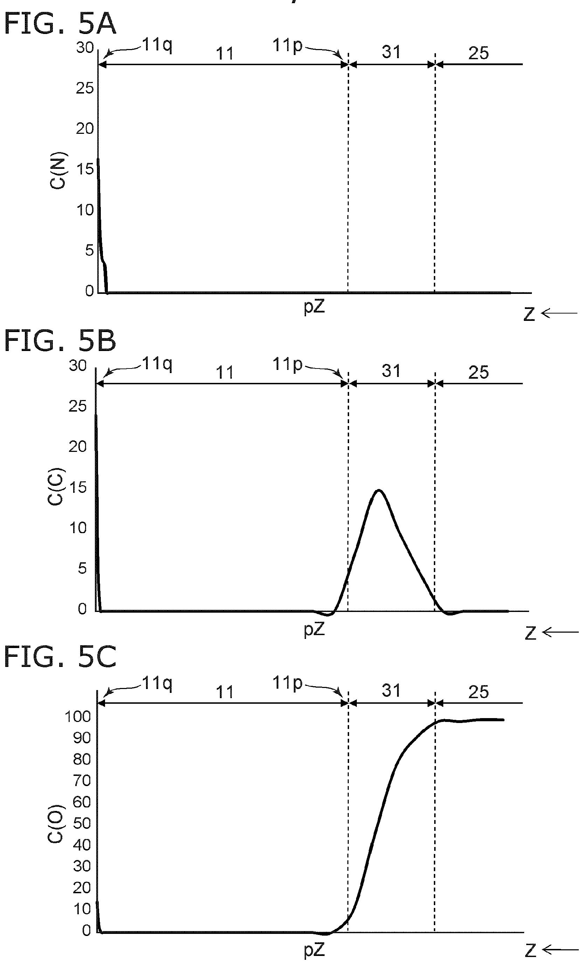

FIGS. 4A and 4B and FIGS. 5A to 5C are graphs illustrating analysis results of the photoelectric conversion element.

These figures illustrate analysis results of XPS (X-ray Photoelectron Spectroscopy) of the photoelectric conversion layer 11. In the analysis samples, the photoelectric conversion layer 11 is formed by coating onto the first layer 31 (an organic layer) formed on the base body 25 of glass. The first conductive layer 21 is omitted from the analysis samples. The perovskite compound 12 includes I and Pb. The first compound 15 includes a urea derivative. The first compound 15 includes N, C, and O. In these figures, the horizontal axis is a position pZ in the Z-axis direction. The vertical axis of FIG. 4A is a concentration C(I) of I. The vertical axis of FIG. 4B is a concentration C(Pb) of Pb. The vertical axis of FIG. 5A is a concentration C(N) of N. The vertical axis of FIG. 5B is a concentration C(C) of C. The vertical axis of FIG. 5C is a concentration C(O) of O. These figures show the base body 25, the first layer 31, and the first and second regions 11p and 11q of the photoelectric conversion layer 11.

In FIGS. 5B and 5C, a high concentration C(C) and a high concentration C(O) are observed in the range that is not in the photoelectric conversion layer 11. This is due to the first layer 31 or the base body 25.

As shown in FIGS. 4A and 4B, the concentration C(I) and the concentration C(Pb) are high in the photoelectric conversion layer 11. These concentrations are due to the perovskite compound 12 included in the photoelectric conversion layer 11.

As shown in FIG. 5A, the concentration C(N) in the second region 11q is greater than the concentration C(N) in the first region 11p in the range of the photoelectric conversion layer 11. As shown in FIG. 5B, the concentration C(C) in the second region 11q is greater than the concentration C(C) in the first region 11p in the range of the photoelectric conversion layer 11. As shown in FIG. 5C, the concentration C(O) in the second region 11q is greater than the concentration C(O) in the first region 11p in the range of the photoelectric conversion layer 11. The concentration C(N), the concentration C(C), and the concentration C(O) are due to the first compound 15.

For example, the first region 11p includes a first nitrogen concentration, a first carbon concentration, and a first oxygen concentration. The second region 11q includes at least one of a second nitrogen concentration that is greater than the first nitrogen concentration, a second carbon concentration that is greater than the first carbon concentration, or a second oxygen concentration that is greater than the first oxygen concentration.

Thus, the concentration of the first compound 15 in the photoelectric conversion layer 11 is nonuniform in the Z-axis direction. For example, the concentration of the first compound 15 in the second region 11q is greater than the concentration of the first compound 15 in the first region 11p.

It is considered that such a nonuniformity of the concentration of the first compound 15 is caused by, for example, the first compound 15 moving toward the surface relative to the perovskite compound 12 (or the perovskite precursor) in a coated film that includes the first compound 15. It is considered that the ordering of the crystal regions of the perovskite compound 12 in the coated film occurs according to the movement of the first compound 15 at a moderate rate. It is considered that a good and dense crystal region in the perovskite compound 12 are easily obtained thereby. It is considered that such ordering of the crystal regions is effectively promoted by the first compound 15. It is considered that a high conversion efficiency is obtained thereby.

Also, because the first compound 15 includes at least one selected from the group consisting of a pyrrolidone derivative, a urea derivative, an imidazole derivative, a pyridine derivative, and a diamine derivative, the dispersibility in the coating liquid of the perovskite precursor that is used to form the perovskite compound 12 is improved. A uniform coated film is easily obtained.

As shown in FIG. 1, the photoelectric conversion layer 11 includes a third region 11r. The third region 11r includes the center of the photoelectric conversion layer 11 in the first direction (the Z-axis direction) from the first conductive layer 21 toward the second conductive layer 22. The concentration of the first compound 15 in the third region 11r is, for example, not less than 0.01 wt% and not more than 50 wt%. The concentration of the first compound 15 in the third region 11r may be, for example, not less than 0.05 wt%. The concentration of the first compound 15 in the third region 11r may be, for example, not more than 20 wt%. The concentration of the first compound 15 in the third region 11r corresponds to the average concentration of the first compound 15 in the photoelectric conversion layer 11.

According to the embodiment, the first compound 15 includes, for example, at least one selected from the group consisting of 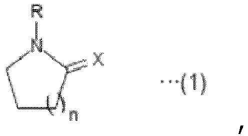 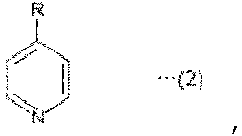 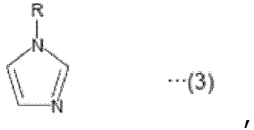 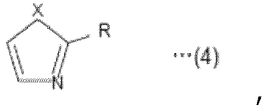 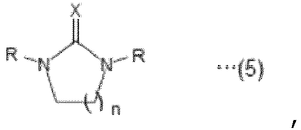 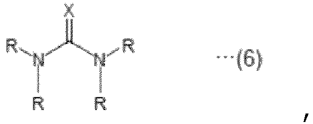 and

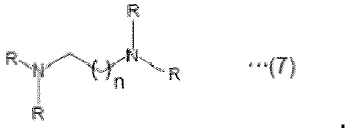

In the compounds of the first to seventh formulas recited above, the "R" recited above is a monovalent group including at least one selected from the group consisting of hydrogen, a linear alkyl group including not less than 1 and not more than 18 carbon atoms, a branched alkyl group including not less than 1 and not more than 18 carbon atoms, a cyclic alkyl group including not less than 1 and not more than 18 carbon atoms, a substituted alkoxy group, a non-substituted alkoxy group, a substituted carbonyl group, a non-substituted carbonyl group, a substituted sulfide group, a non-substituted sulfide group, a substituted sulfonyl group, a non-substituted sulfonyl group, a substituted sulfoxide group, a non-substituted sulfoxide group, a substituted aryl group, a non-substituted aryl group, a substituted heteroaryl group, and a non-substituted heteroaryl group. "X" recited above is an oxygen atom or a sulfur atom. "n" recited above is an integer not less than 0 and not more than 4.

According to the embodiment, the perovskite compound 12 includes at least one of a compound represented by A¹BX¹₃ or a compound represented by A²₂A¹_{*m*-1}B*ₘ*X¹_{3*m*+1}. The "A¹" recited above is a monovalent cation including at least one selected from the group consisting of Cs⁺, Rb⁺, K⁺, Na⁺, R¹NH₃⁺, R¹₂NH₂⁺, and HC(NH₂)₂⁺. The "R¹" in the "A¹" is at least one monovalent group selected from the group consisting of hydrogen, a linear alkyl group including not less than 1 and not more than 18 carbon atoms, a branched alkyl group including not less than 1 and not more than 18 carbon atoms, a cyclic alkyl group including not less than 1 and not more than 18 carbon atoms, a substituted aryl group, a non-substituted aryl group, a substituted heteroaryl group, and a non-substituted heteroaryl group. The "A²" recited above is a monovalent cation including at least one selected from the group consisting of R¹HN₃⁺, R¹₂NH₂⁺, C(NH₂)₃⁺, and R²C₂H₄NH₃⁺. The "R²" in the "A²" is at least one monovalent group selected from the group consisting of a substituted aryl group, a non-substituted aryl group, a substituted heteroaryl group, and a non-substituted heteroaryl group. The "B" recited above is a divalent cation including at least one selected from the group consisting of Pb₂⁺, Sn₂⁺, and Ge₂⁺. The "X¹" recited above is at least one monovalent negative ion selected from the group consisting of F⁻, Cl⁻, Br⁻, I⁻, SCN⁻, and CH₃COO⁻. "m" recited above is an integer not less than 1 and not more than 20.

In the third region 11r of the photoelectric conversion layer 11, the ratio of the number of the first compounds 15 to the sum of numbers of the A¹ recited above and the A² recited above in the at least one of the compound represented by A¹BX¹₃ recited above or the compound represented by A²₂A¹_{*m*-1},B*ₘ*X¹_{3*m*+1} recited above is not less than 0.001 and not more than 0.5. For example, a high conversion efficiency is easily obtained by the first compound 15 having such a concentration. For example, good dispersibility is obtained for a coating liquid corresponding to the first compound 15 that has such a concentration. A uniform coated film is obtained, and a uniform photoelectric conversion layer 11 is easily obtained.

For example, the ratio of the amount of the first compound 15 to the amount of the monovalent cations of the perovskite compound 12 in the photoelectric conversion layer 11 is, for example, not less than 0.01 mol%. The ratio may be, for example, not less than 0.1 mol%. The ratio may be, for example, not less than 0.5 mol%. The ratio may be not less than 10 mol%. For example, a high conversion efficiency is easily obtained.

For example, the ratio of the amount of the first compound 15 in the photoelectric conversion layer 11 to the amount of the divalent cations of the perovskite compound 12 in the photoelectric conversion layer 11 is not more than 100 mol%. The ratio may be, for example, not more than 50 mol%. The ratio may be, for example, not more than 20 mol%. For example, a perovskite structure is easily maintained.

According to the embodiment, a thickness t11 of the photoelectric conversion layer 11 (referring to FIG. 1) is, for example, not less than 30 nm and not more than 1000 nm. By setting the thickness t11 to be not less than 30 nm, for example, the light can be efficiently absorbed, and a high short-circuit current density is obtained. By setting the thickness t11 to be not more than 1000 nm, for example, an excessively long carrier transport distance is suppressed. For example, the reduction of the conversion efficiency can be suppressed.

A thickness t31 of the first layer 31 (referring to FIG. 1) is, for example, not less than 1 nm and not more than 200 nm. A thickness t32 of the second layer 32 (referring to FIG. 1) is, for example, not less than 1 nm and not more than 200 nm. The thickness t11, the thickness t31, and the thickness t32 are lengths along the Z-axis direction.

At least one of the first layer 31 or the second layer 32 includes, for example, at least one selected from the group consisting of polyaniline, a polyaniline derivative, polythiophene, a polythiophene derivative, and polyethylene dioxythiophene:polystyrenesulfonic acid (PEDOT:PSS). At least one of the first layer 31 or the second layer 32 may include, for example, fullerene.

At least one of the first layer 31 or the second layer 32 may include, for example, at least one selected from the group consisting of titanium oxide, zinc oxide, molybdenum oxide, tungsten oxide, aluminum oxide, copper oxide, vanadium oxide, nickel oxide, lithium oxide, calcium oxide, cesium oxide, lithium fluoride (LiF), and metal calcium.

The first layer 31 and the second layer 32 can be formed by, for example, at least one of vapor deposition or printing.

The first conductive layer 21 includes, for example, a metal oxide. The metal oxide includes, for example, oxygen and at least one selected from the group consisting of indium, zinc, and tin. The first conductive layer 21 may include, for example, at least one selected from the group consisting of gold, platinum, silver, copper, cobalt, nickel, indium, and aluminum. In one example, the light transmittance of the first conductive layer 21 is greater than the light transmittance of the second conductive layer 22. The light transmittance may be, for example, the transmittance for visible light.

The second conductive layer 22 includes, for example, at least one selected from the group consisting of silver, gold, aluminum, copper, titanium, platinum, nickel, tin, zinc, chrome, and lithium. The second conductive layer 22 may include, for example, a metal oxide. The second conductive layer 22 may include, for example, at least one selected from the group consisting of a conductive polymer, graphene, and a carbon nanotube.

For example, the base body 25 may be light-transmissive. The base body 25 may include, for example, at least one selected from the group consisting of a resin and glass. The surface of the base body 25 may include an unevenness. The light from the outside can be caused to be efficiently incident.

### Second embodiment

A second embodiment relates to a coating liquid. The coating liquid according to the embodiment includes a solvent, the first compound 15, and a perovskite precursor that is used to form the perovskite compound 12. The first compound 15 includes at least one selected from the group consisting of a pyrrolidone derivative, a urea derivative, an imidazole derivative, a pyridine derivative, and a diamine derivative. The first compound 15 includes, for example, at least one of the compounds of the first to sixth formulas recited above.

The concentration of the first compound 15 in the coating liquid is, for example, not less than 0.01 wt% and not more than 10 wt%.

The boiling point of the solvent recited above is, for example, not more than 200 °C. For example, the coating liquid is quickly and easily solidified. The boiling point may be, for example, not more than 165 °C. The boiling point may be, for example, not more than 140 °C.

The solvent includes, for example, at least one selected from the group consisting of an aliphatic hydrocarbon, an aromatic hydrocarbon, an alicyclic hydrocarbon, an alcohol, an aliphatic ketone, an ester, a nitrile, a halogen hydrocarbon, an ether, an amide, and a sulfoxide.

The solvent may include, for example, at least one selected from the group consisting of hexane, heptane, octane, isooctane, nonane, and decane. The solvent may include, for example, at least one selected from the group consisting of toluene and chlorobenzene. The solvent may include at least one selected from the group consisting of cyclopentane, cyclohexane, methylcyclohexane, cycloheptane, and cyclooctane. The solvent may include, for example, at least one selected from the group consisting of methanol, ethanol, propanol, 2-methoxyethanol, and 2-ethoxyethanol. The solvent may include, for example, at least one selected from the group consisting of acetone and methyl ethyl ketone. The solvent may include, for example, at least one selected from the group consisting of ethyl formate, isopropyl formate, ethyl acetate, and propyl acetate. The solvent may include at least one selected from the group consisting of acetonitrile, propanenitrile, and isobutyl nitrile. The solvent may include, for example, at least one selected from the group consisting of chloroform, methylene chloride, dichloroethane, trichloroethane, and trichloroethylene. The solvent may include at least one selected from the group consisting of diethylether, tetrahydrofuran, and 1,4-dioxane. The solvent may include, for example, at least one selected from the group consisting of N,N-dimethylformamide, N,N-dimethylacetamide, and dimethylsulfoxide.

In the coating liquid, the perovskite precursor that is used to form the perovskite compound 12 includes, for example, at least one of a compound represented by A¹X¹, a compound represented by A²X¹, or a compound represented by BX¹₂. The "A¹" and the "A²" are monovalent cations. The monovalent cations include at least one selected from the group consisting of an alkaline metal cation and organic ammonium. "B" is a divalent cation. The divalent cation includes, for example, at least one selected from the group consisting of tin, lead, and germanium. The "X" is a monovalent negative ion. The monovalent negative ion includes, for example, at least one selected from the group consisting of a halide ion, an acetate ion, and a thiocyanate ion. The A¹X¹ includes, for example, at least one selected from the group consisting of methylammonium iodide, methylammonium bromide, methylammonium chloride, methylammonium acetate, formamidinium iodide, formamidinium bromide, formamidinium chloride, cesium iodide, cesium bromide, cesium chloride, rubidium iodide, and potassium iodide. The A²X¹ includes, for example, at least one selected from the group consisting of guanidinium bromide, guanidinium bromide, guanidinium thiocyanate, phenylethylammonium iodide, and butylammonium iodide. The BX¹₂ includes, for example, at least one selected from the group consisting of lead iodide (II), lead bromide (II), lead chloride (II), lead acetate (II), lead thiocyanate (II), tin iodide (II), tin bromide (II), tin chloride (II), tin fluoride (II), and germanium iodide (II).

By using the coating liquid according to the embodiment, the photoelectric conversion layer 11 that has a high conversion efficiency can be efficiently formed. The photoelectric conversion layer 11 that has a large area is obtained with high productivity. A photoelectric conversion element can be provided in which the characteristics can be improved.

### Third embodiment

A third embodiment relates to a coating method.

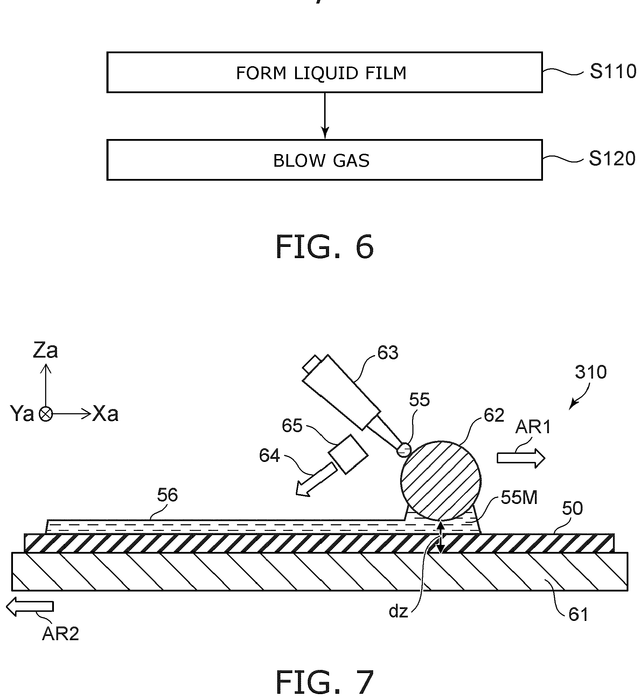

FIG. 6 is a flowchart illustrating the coating method according to the third embodiment.

FIG. 7 is a schematic side view illustrating a coating apparatus used in the coating method according to the third embodiment.

As shown in FIG. 7, the coating apparatus 310 includes, for example, a supporter 61, a coating bar 62, a coating liquid supplier 63, and a gas supplier 65. The supporter 61 is configured to support a coated body 50. The coated body 50 includes, for example, the base body 25 and the first conductive layer 21. The coated body 50 may further include the first layer 31. Coating is performed onto the surface of the coated body 50. The supporter 61 may be, for example, a stage, etc.

The coating bar 62 is located above the supporter 61.

The coating liquid supplier 63 supplies a coating liquid 55 toward at least one of the coating bar 62 or the coated body 50. The coating liquid supplier 63 is configured to coat the coating liquid 55 onto the coated body 50 by forming a meniscus 55M that includes the coating liquid 55 between the coating bar 62 and the coated body 50. The coating liquid supplier 63 may include, for example, a syringe, etc.

For example, the coating bar 62 is movable relative to the supporter 61 (i.e., the coated body 50) along arrow AR1. The supporter 61 (i.e., the coated body 50) may be movable relative to the coating bar 62 along arrow AR2. The coating liquid 55 of the meniscus 55M is coated onto the coated body 50 according to the movement. Thereby, the coated film 56 is formed of the coating liquid 55 on the surface of the coated body 50.

The gas supplier 65 is configured to supply a gas 64 toward the coating liquid 55 (i.e., the coated film 56) coated onto the coated body 50. The solvent in the coated film 56 is vaporized by the gas 64; and the coated film 56 is solidified. Subsequently, heat treatment, etc., may be performed as necessary. Thereby, a layer (e.g., the photoelectric conversion layer 11) is obtained based on the coating liquid 55.

In the coating method according to the embodiment as shown in FIG. 6, the coating liquid 55 is coated onto the coated body 50 (step S110). The coating liquid 55 includes a solvent, the first compound 15, and the perovskite precursor that is used to form the perovskite compound 12. When coating, the coating liquid 55 is coated onto the coated body 50 by forming the meniscus 55M that includes such a coating liquid 55 between the coating bar 62 and the coated body 50.

In the coating method according to the embodiment, the gas 64 is supplied toward the coating liquid 55 (i.e., the coated film 56) coated onto the coated body 50 (step S120). According to the embodiment, the flow velocity of the gas 64 is, for example, not less than 4 m/s. The "flow velocity of the gas 64" is defined as the maximum air velocity of the gas on the substrate that is supplied onto the coated film 56 on the substrate. For example, the maximum air velocity of the gas 64 at the surface of the coating liquid 55 is not less than 4 m/s. In the coating method according to the embodiment, the photoelectric conversion layer 11 is formed from the coating liquid 55.

For example, the occurrence of gaps between the multiple crystal regions can be suppressed by a flow velocity that is not less than 4 ms/s. For example, a dense photoelectric conversion layer 11 is easily obtained.

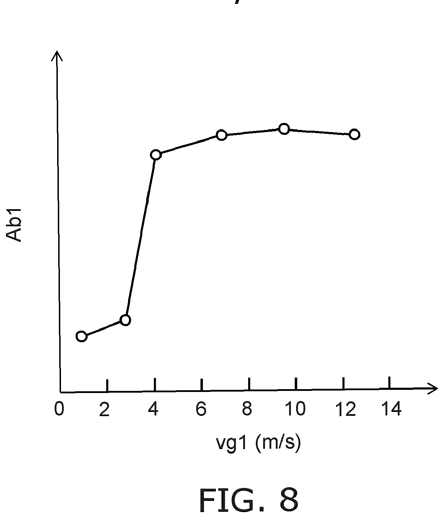

FIG. 8 is a graph illustrating a characteristic relating to the coating method.

The horizontal axis of FIG. 8 is a flow velocity vg1 of the gas 64. The vertical axis is an absorbance Ab1 of the photoelectric conversion layer 11 for a wavelength of 700 nm. A high absorbance Ab1 corresponds to small gaps between the multiple crystal regions in the photoelectric conversion layer 11. As shown in FIG. 8, the absorbance Ab1 is low when the flow velocity vg1 is less than 4 m/s. A high absorbance Ab1 is obtained when the flow velocity vg1 is not less than 4 m/s. According to the embodiment, for example, it is favorable for the flow velocity vg1 to be not less than 4 m/s, more favorably 6 m/s, and more favorably not less than 8 m/s. The flow velocity vg1 is, for example, not more than 40 m/s. It is more favorable for the flow velocity vg1 to be not more than 30 m/s, and more favorably not more than 25 m/s. By setting the flow velocity vg1 to be not more than 40 m/s, for example, scattering of the coating liquid 55 can be suppressed.

According to the embodiment, the gas 64 includes, for example, at least one selected from the group consisting of nitrogen, helium, neon, argon, and air. For example, oxidization of the perovskite compound 12 is suppressed thereby.

The boiling point of the solvent is, for example, not more than 200 °C. The boiling point may be not more than 165 °C. The boiling point may be not more than 140°C. For example, the occurrence of gaps between the multiple crystal regions can be suppressed thereby. For example, a dense photoelectric conversion layer 11 is easily obtained.

According to the embodiment, the coating of the coating liquid 55 onto the coated body 50 includes relatively moving the coated body 50 and the coating bar 62. The rate of the relative movement is, for example, not less than 20 mm/s. For example, high productivity is obtained by setting the rate of the relative movement to be not less than 20 mm/s. The rate of the relative movement may be not more than 200 mm/s. An excessive supply of the coating liquid 55 onto the coated body 50 is suppressed thereby, and, for example, a delay of the drying of the solvent can be suppressed. For example, when the rate of the relative movement is greater than 200 mm/s, the flatness is poor, and the gaps between the crystal regions are highly noticeable.

As shown in FIG. 7, the orientation of the supply of the gas 64 is along the relative movement direction of the coated body 50. For example, a uniform coated film 56 is easily obtained.

According to the embodiment, the first compound 15 includes, for example, at least one selected from the group consisting of a pyrrolidone derivative, a urea derivative, an imidazole derivative, a pyridine derivative, and a diamine derivative. A uniform and stable coating liquid 55 is obtained thereby. For example, a high conversion efficiency is obtained in the photoelectric conversion layer 11 that is formed from the coating liquid 55. According to the embodiment, a coating method for a photoelectric conversion element can be provided in which the characteristics can be improved.

As shown in FIG. 7, the distance (e.g., the shortest distance) between the supporter 61 and the coating bar 62 is taken as a distance dz. The distance dz may be modifiable according to the relative movement of the coating bar 62 and the coated body 50. For example, the distance dz may change between the end portion of the coating region and the central portion of the coating region. The thickness of the coated film 56 can be more uniform thereby.

For example, the direction from the supporter 61 toward the coating bar 62 is taken as a Za-direction. One direction perpendicular to the Za-direction is taken as an Xa-direction. A direction perpendicular to the Za-direction and the Xa-direction is taken as a Ya-direction. The distance dz is the length along the Za-direction. The direction of the relative movement (e.g., arrow AR1 or arrow AR2) is along the Xa-direction.

### Fourth embodiment

A fourth embodiment relates to a coating apparatus. For example, the coating apparatus 310 according to the embodiment may have the configuration illustrated in FIG. 7. The coating apparatus 310 includes, for example, the supporter 61, the coating bar 62, the coating liquid supplier 63, and the gas supplier 65 (referring to FIG. 7). In the gas supplier 65, the flow velocity vg1 of the gas 64 is, for example, not less than 4 m/s. The flow velocity vg1 of the gas 64 may be, for example, not more than 40 m/s. The orientation of the supply of the gas 64 is along the relative movement direction of the coated body 50. The first compound 15 that is included in the coating liquid 55 includes at least one selected from the group consisting of a pyrrolidone derivative, a urea derivative, an imidazole derivative, a pyridine derivative, and a diamine derivative. According to the coating apparatus 310 according to the embodiment, an appropriate flow velocity vg1 can be supplied. In the coated film 56, gaps between the multiple crystal regions are suppressed, and defects are suppressed.

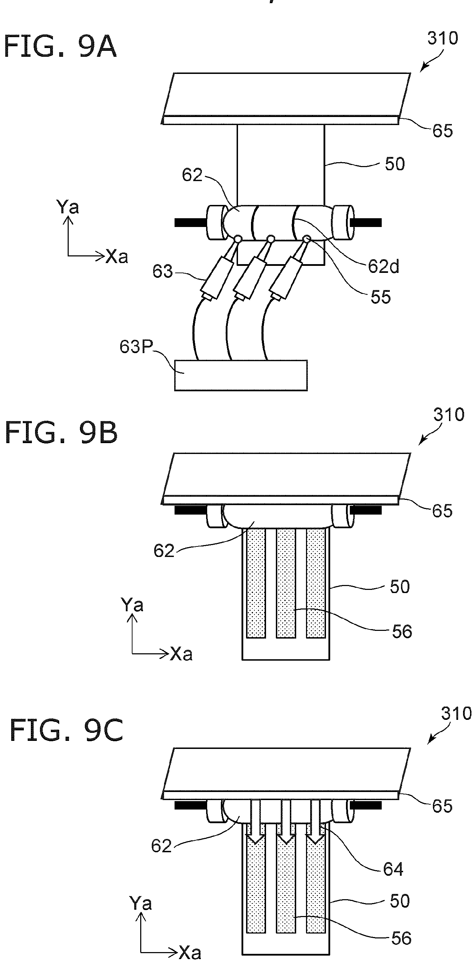

FIGS. 9A to 9C are schematic views illustrating the coating apparatus according to the fourth embodiment.

These drawings are top views. As shown in FIG. 9A, for example, the coating liquid 55 is supplied from a pump 63P toward the coating liquid supplier 63. The coating liquid supplier 63 supplies the coating liquid 55 toward the coating bar 62 (or the coated body 50). A recess 62d may be provided in the coating bar 62. The recess 62d is, for example, a groove. For example, a more uniform meniscus 55M can be stably formed.

In the example as shown in FIG. 9B, the coating bar 62 moves along the Ya-direction; and the coated film 56 is formed on the coated body 50.

As shown in FIG. 9C, the gas 64 is supplied from the gas supplier 65 toward the coating liquid 55 (the coated film 56) that is coated.

According to the first to fourth embodiments described above, the coating liquid 55 includes, for example, lead iodide (PbI₂) (461 mg), methylammonium iodide (CH₃NH₃I:MAI) (152 mg), N-methylpyrrolidone (20 mg), acetone (0.63 mL), and N,N-dimethylformamide (0.42 mL). Lead iodide (PbI₂) and methylammonium iodide (CH₃NH₃I:MAI) are examples of the perovskite precursor that is used to form the perovskite compound 12. The coating liquid 55 is uniform.

In a first reference example, the coating liquid 55 includes dimethylsulfoxide (20 mg) but does not include N-methylpyrrolidone. Needle-like crystals precipitate in the coating liquid 55 of the first reference example. For example, it is considered that this is because the solubility of a complex of MAPbI₃ and dimethylsulfoxide is low.

For example, the photoelectric conversion element according to the embodiment is applicable to a solar cell, a light-emitting element, a light sensor, etc. For example, a perovskite compound is used as the photoelectric conversion material of the photoelectric conversion element. For example, a photoelectric conversion layer that has a large area is inexpensively obtained by forming the photoelectric conversion layer by coating. For example, there is a method (a 2-step technique) in which an organic component is coated after coating a film of an inorganic component when forming the photoelectric conversion layer by coating. According to the embodiment, a 1-step technique is possible in which the solution of the perovskite compound is coated in one step.

According to embodiments, a photoelectric conversion element, a coating liquid, a coating method, and a coating apparatus can be provided in which the characteristics can be improved.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in photoelectric conversion elements such as conductive layers, photoelectric conversion layers, etc., from known art. Such practice is included in the scope of the invention to the extent that similar effects thereto are obtained.

Further, any two or more components of the specific examples may be combined within the extent of technical feasibility and are included in the scope of the invention to the extent that the purport of the invention is included.

Moreover, all photoelectric conversion elements, coating liquids, coating methods, and coating apparatuses practicable by an appropriate design modification by one skilled in the art based on the photoelectric conversion elements, the coating liquids, the coating methods, and the coating apparatuses described above as embodiments of the invention also are within the scope of the invention to the extent that the purport of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A photoelectric conversion element, comprising:
a first conductive layer;
a second conductive layer; and
a photoelectric conversion layer located between the first conductive layer and the second conductive layer,
the photoelectric conversion layer including a perovskite compound and a first compound,
the first compound including at least one selected from the group consisting of a pyrrolidone derivative, a urea derivative, an imidazole derivative, a pyridine derivative, and a diamine derivative.

2. The element according to claim 1, wherein
the photoelectric conversion layer includes a first region, and a second region between the first region and the second conductive layer,
the first region includes a first nitrogen concentration, a first carbon concentration, and a first oxygen concentration,
the second region includes at least one of a second nitrogen concentration, a second carbon concentration, or a second oxygen concentration,
the second nitrogen concentration is greater than the first nitrogen concentration,
the second carbon concentration is greater than the first carbon concentration, and
the second oxygen concentration is greater than the first oxygen concentration.

3. The element according to claim 1, wherein
the photoelectric conversion layer includes a first region, and a second region between the first region and the second conductive layer, and
a concentration of the first compound in the second region is greater than a concentration of the first compound in the first region.

4. The element according to one of claims 1-3, wherein
the photoelectric conversion layer includes a third region including a center of the photoelectric conversion layer in a first direction,
the first direction is from the first conductive layer toward the second conductive layer, and
a concentration of the first compound in the third region is not less than 0.01 wt% and not more than 10 wt%.

5. The element according to one of claims 1-3, wherein
the perovskite compound includes at least one of a compound expressed by A¹BX¹₃ or a compound expressed by A²₂A¹_{*m*-1}B*ₘ*X¹_{3*m*+1},
the A¹ is a monovalent cation including at least one selected from the group consisting of Cs⁺, Rb⁺, K⁺, Na⁺, R¹NH₃⁺, R¹₂NH₂⁺, and HC(NH₂)₂⁺,
the R¹ in the A¹ is at least one monovalent group selected from the group consisting of hydrogen, a linear alkyl group including not less than 1 and not more than 18 carbon atoms, a branched alkyl group including not less than 1 and not more than 18 carbon atoms, a cyclic alkyl group including not less than 1 and not more than 18 carbon atoms, a substituted aryl group, a non-substituted aryl group, a substituted heteroaryl group, and a non-substituted heteroaryl group,
the A² is a monovalent cation including at least one selected from the group consisting of R¹HN₃⁺, R¹₂NH₂⁺, C(NH₂)₃⁺, and R²C₂H₄NH₃⁺,
the R² in the A² is at least one monovalent group selected from the group consisting of a substituted aryl group, a non-substituted aryl group, a substituted heteroaryl group, and a non-substituted heteroaryl group,
the B is a divalent cation including at least one selected from the group consisting of Pb₂⁺, Sn₂⁺, and Ge₂⁺,
the X¹ is at least one monovalent negative ion selected from the group consisting of F⁻, Cl⁻, Br⁻, I⁻, SCN⁻, and CH₃COO⁻, and
m is an integer not less than 1 and not more than 20.

6. The element according to one of claims 1-5, wherein
the first compound includes at least one selected from the group consisting of: 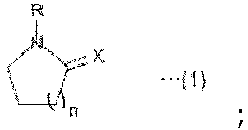 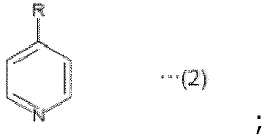 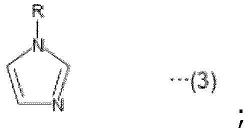 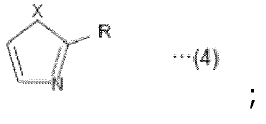 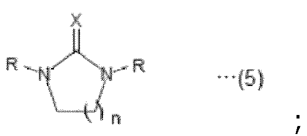 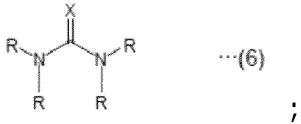 and 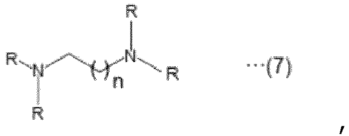
the R is a monovalent group including at least one selected from the group consisting of hydrogen, a linear alkyl group including not less than 1 and not more than 18 carbon atoms, a branched alkyl group including not less than 1 and not more than 18 carbon atoms, a cyclic alkyl group including not less than 1 and not more than 18 carbon atoms, a substituted alkoxy group, a non-substituted alkoxy group, a substituted carbonyl group, a non-substituted carbonyl group, a substituted sulfide group, a non-substituted sulfide group, a substituted sulfonyl group, a non-substituted sulfonyl group, a substituted sulfoxide group, a non-substituted sulfoxide group, a substituted aryl group, a non-substituted aryl group, a substituted heteroaryl group, and a non-substituted heteroaryl group,
the X is an oxygen atom or a sulfur atom,
*n* is an integer not less than 0 and not more than 4,
the photoelectric conversion layer includes a third region including a center of the photoelectric conversion layer in a first direction,
the first direction is from the first conductive layer toward the second conductive layer,
a ratio of a number of the first compounds to a sum of numbers of the A¹ and the A² of the at least one of the compound expressed by A¹BX¹₃ or the compound expressed by A²₂A¹_{*m*-1}B*ₘ*X¹_{3*m*+1} in the third region is not less than 0.001 and not more than 0.5.

7. The element according to one of claims 1-5, wherein
the first compound includes at least one selected from the group consisting of: 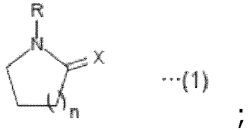 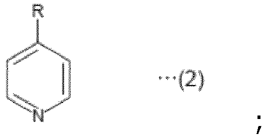 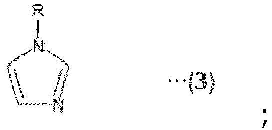 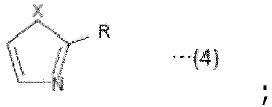 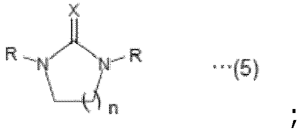 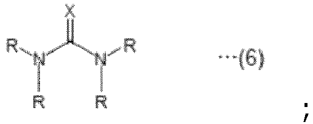 and 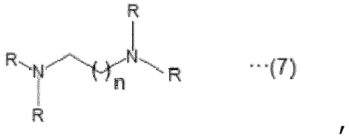
the R is a monovalent group including at least one selected from the group consisting of hydrogen, a linear alkyl group including not less than 1 and not more than 18 carbon atoms, a branched alkyl group including not less than 1 and not more than 18 carbon atoms, a cyclic alkyl group including not less than 1 and not more than 18 carbon atoms, a substituted alkoxy group, a non-substituted alkoxy group, a substituted carbonyl group, a non-substituted carbonyl group, a substituted sulfide group, a non-substituted sulfide group, a substituted sulfonyl group, a non-substituted sulfonyl group, a substituted sulfoxide group, a non-substituted sulfoxide group, a substituted aryl group, a non-substituted aryl group, a substituted heteroaryl group, and a non-substituted heteroaryl group,
the X is an oxygen atom or a sulfur atom, and
*n* is an integer not less than 0 and not more than 4.

8. A coating method, comprising:
coating a coating liquid onto a coated body by forming a meniscus between a coating bar and the coated body,
the meniscus including the coating liquid,
the coating liquid including a perovskite precursor, a first compound, and a solvent,
the perovskite precursor being used to form a perovskite compound; and
forming a photoelectric conversion layer from the coating liquid by supplying a gas toward the coating liquid coated onto the coated body,
a maximum air velocity of the gas at the coating liquid surface being not less than 4 m/s.

9. The method according to claim 8, wherein
the gas includes at least one selected from the group consisting of nitrogen, helium, neon, argon, and air.

10. The method according to claim 8 or 9, wherein
a boiling point of the solvent is not more than 200 °C.

11. The method according to one of claims 8-10, wherein
the coating of the coating liquid onto the coated body includes relatively moving the coated body and the coating bar, and
a rate of the relative movement is not less than 20 mm/s.

12. The method according to one of claims 8-11, wherein
an orientation of the supply of the gas is along a relative movement direction of the coated body.

13. The method according to one of claims 8-12, wherein
the first compound includes at least one selected from the group consisting of a pyrrolidone derivative, a urea derivative, an imidazole derivative, a pyridine derivative, and a diamine derivative.
